# EUROPEAN PATENT APPLICATION

(11) **EP 4 064 322 A1**
(43) Date of publication of application: **28.09.2022**
(21) Application number: 22163312.6
(22) Date of filing: 21.03.2022
(51) Int. Cl.: H01J 37/22, B23K 26/12

(54) **IN-SITU LASER REDEPOSITION REDUCTION BY A CONTROLLED GAS FLOW AND A SYSTEM FOR REDUCING CONTAMINATION**

(30) Priority: 24.03.2021 US 202117211657
(71) Applicant: FEI Company, Hillsboro, OR 97124-5793 (US)
(72) Inventor: Gancarcik, Tomás, 5602 BS Eindhoven (NL); Dekan, Ivan, 5602 BS Eindhoven (NL); Krobot, David, 5602 BS Eindhoven (NL); Trnkócy, Tomás, 5602 BS Eindhoven (NL); Randolph, Steven, 5602 BS Eindhoven (NL); Geurts, Remco, 5602 BS Eindhoven (NL)
(74) Representative: Janssen, Francis-Paul

(57) **Abstract**

Deposition of debris produced in laser ablation of a workpiece situated in a vacuum chamber is reduced by introduction a background gas into the vacuum chamber prior to or during laser ablation. The background gas can be introduced diffusely into the vacuum chamber and can reduce contamination of surfaces such as a surface of an optical window that faces the workpiece during processing. Directed introduction of a background gas can be used as well and in some cases the same or a different background gas is directed to a workpiece surface at the same or different pressure than that associated with diffuse introduction of the background gas to reduce contamination of the workpiece surface with laser ablation debris.

## Description

### FIELD

The disclosure pertains to reduction of surface contamination in laser processing.

### BACKGROUND

Many workflows combine focused ion beam (FIB) milling and laser ablation in a vacuum chamber. In laser ablation processes, large amounts of material can be removed and this removed material can be deposited on surfaces in the vacuum chamber. The optical system used to deliver a laser beam can exhibit reduced optical transmission due to such redeposition. To protect optical components, a final surface of the laser optical system can be an inexpensive window that can be replaced as needed. However, window replacement requires cessation of processing and venting the vacuum chamber, complicating and delaying processing. One approach to protecting optical components is describe in Straw, U.S. Patent 9,216,47. In one example, Straw discloses scrolling a transparent cover across the face of an optical objective so that a contaminated portion of the cover is replaced with an uncontaminated portion. This approach can extend optical window useful lifetime, but increases system complexity and alternative approaches are needed.

### SUMMARY

Redeposition contamination by debris from ablation processing can be reduced or eliminated by introducing a background gas into a processing chamber. Such a background gas can be introduced diffusely or remotely and need not be directed to surfaces on which debris deposition is to be reduced, By providing the background gas at a suitable pressure greater than that used in ion beam processing or electron microscope but less than atmospheric pressure, contamination of optical surfaces facing a workpiece can be reduced, extending optical window useful lifetimes. While the background gas can protect optical surfaces, adjacent portions of the workpiece can receive redeposited debris. In some examples, a background gas is introduced via a nozzle or otherwise directed to a workpiece surface to reduce this redeposition. Deposition of debris near processing locations can also be reduced using a reactive gas to volatilize debris or an additional laser processing step can be used to remove workpiece debris.

Representative methods of laser and ion beam processing include situating a workpiece in a vacuum chamber and establishing a background gas pressure of between about 1 Pa and 10 kPa in the vacuum chamber. A laser beam is directed to the workpiece to ablate a portion of the workpiece. The background gas pressure at between 10⁻⁴ Pa and 10 kPa can be established by introducing a background gas into the vacuum chamber. The vacuum chamber can be isolated from a vacuum pump coupled to the vacuum chamber when introducing the background gas into the vacuum chamber. The background gas can be one or more of nitrogen, water vapor, carbon dioxide, oxygen, a noble gas, or a fluorocarbon or other halogenated compounds. The background gas can be introduced to the vacuum chamber at a location remote from the ablated portion of the workpiece and may or may not be directed to the workpiece at or near a location subjected to laser processing such as laser ablation. In some examples, a pumping rate of the vacuum pump is reduced prior to or as the background gas pressure is established. The vacuum pressure in the vacuum chamber can be reestablished without venting the vacuum chamber and the workpiece then processed or imaged with a charged-particle beam (CPB). In some cases, the background gas is introduced to the vacuum chamber by directing the background gas toward a surface of the workpiece. In some examples, the background gas is introduced to be directed to a surface in the vacuum chamber and to be diffusely introduced.

A representative processing apparatus comprises a vacuum chamber and a laser optical system that includes an objective situated within the vacuum chamber and operable to direct an optical processing beam to a workpiece to remove material from the workpiece. A charged-particle-beam optical system is situated to direct a charged particle beam (CPB) to the workpiece and a process controller is coupled to the vacuum chamber to introduce a background gas to inhibit deposition of workpiece material on the laser optical system during processing with the laser optical system. A valve responsive to the process controller can be situated to introduce the background gas into the vacuum chamber and the background gas can be one or more of nitrogen, oxygen, carbon dioxide, a fluorocarbon, XeF₂, SiF4, or other halogenated gas, or a noble gas. The process controller is operable to introduce the background gas to produce a vacuum chamber pressure greater than 1 Pa. In some examples, a pressure gauge is situated to measure pressure in the vacuum chamber, wherein the process controller is coupled to the pressure gauge and is operable to introduce the background gas into the vacuum chamber based on the measured pressure. A gas outlet can be situated to direct a flow of the background gas to a surface of the workpiece. In some examples, a vacuum pump is coupled to the vacuum chamber and is operable to evacuate the vacuum chamber, wherein the process controller is configured to decrease an evacuation rate of the vacuum pump from the vacuum chamber in association with introduction of the background gas. Thee vacuum pump can be a turbomechanical pump and the process controller is operable to decrease the evacuation rate by slowing the turbomechanical pump. In still further examples, a pump valve couples the vacuum pump to the vacuum chamber, wherein the process controller is operable to decrease the evacuation rate by adjusting the pump valve. The CPB optical system can be a plasma focused ion beam system and the process controller can be operable to mill the workpiece prior to or after laser ablation without venting the vacuum chamber. The CPB optical system can be an electron microscope system and the process controller can be operable to ablate the workpiece with the optical processing beam and image the ablated workpiece without venting the vacuum chamber.

A representative system for ion beam and laser beam milling of a workpiece retained in a vacuum chamber includes a laser optical system that includes an optical surface facing a workpiece area and a background gas source operable to introduce a background gas into the vacuum chamber to establish a pressure suitable to reduce laser ablation debris deposited on the optical surface facing the workpiece. The laser optical system is operable to ablate the workpiece within the vacuum chamber at the established pressure. An ion beam system is operable to mill the workpiece with an ion beam and a process controller is coupled to the laser optical system, the background gas source, and the ion beam system and configured to select laser ablation with background gas in the vacuum chamber or ion beam milling without venting the vacuum chamber.

The foregoing and other features of the disclosed technology will become more apparent from the following detailed description, which proceeds with reference to the accompanying figures.

### BRIEF DESCRIPTION OF THE DRAWINGS

FIG. 1 illustrates a representative laser processing system that includes a vacuum chamber into which a background gas can be introduced.
FIG. 1A illustrates a directed background gas flow.
FIG. 2 illustrates a representative method of laser processing a workpiece situated in a vacuum chamber.
FIGS. 3A-3B illustrate the effects of a background gas on optical window transmission.
FIG. 4 illustrates a representative method of selecting a background gas for use during laser ablation.
FIG. 5 illustrates a representative system for use in ion beam milling, electron beam imaging, and laser ablation in which a background gas can be introduced for laser ablation.
FIG. 6 illustrates a representative computer environment for use with the disclosed approaches.

### DETAILED DESCRIPTION

### Introduction and General Considerations

Redeposition contamination by debris from laser ablation, laser milling, or other processes applied to workpieces situated in a vacuum chamber for ion beam milling or inspection using electron microscopy can be reduced or eliminated by introducing a background gas into the vacuum chamber. As used herein, "background gas" refers to a gas that is introduced into the vacuum chamber generally with or without being directed toward a workpiece. A background gas can have a single constituent or be a mixture of multiple gases. In some examples, such a background gas is directed to the workpiece(s) via a nozzle, tube, or guide, typically to produce a gas flow at a surface to be ablated or milled or other surfaces to be protected such as laser objectives, charged-particle-beam detectors, optical detectors, camera windows, or other surfaces. In a vacuum, ablation debris is generally directed along an axis normal to a work surface and along a laser beam axis and can be described with a cosine distribution. Introduction of background gas can be particularly useful in reducing contamination of laser optics used to direct a laser processing beam to the workpiece. In some cases, an optical window is situated to protect the laser optics and tends to become less transparent due to contamination. Providing a background gas can reduce this contamination and increase the useful lifetime of the optical window. While the optical window can be inexpensive and mechanically straightforward to replace, replacement can require venting the processing chamber, slowing processing throughput.

While introduction of a background gas can reduce contamination of vacuum chamber surfaces generally, in some cases, the background gas can result in increased contamination on the workpiece, generally at locations adjacent to ablated areas. This debris can be reduced with a directed gas flow of a background gas, or debris can be removed with a subsequent low power laser beam exposure in these adjacent areas. Deposition of debris near processing locations can also be reduced using a reactive gas as the background gas or including a reactive gas in the background gas to volatilize debris.

While the examples below are described with reference to laser ablation, in other examples, other optical processing such as welding, annealing, melting, vaporizing, milling, cutting in which workpiece material tends to be removed from the workpiece can be similarly arranged. In the examples, optical processing of workpieces is performed with the workpiece situated in a chamber that is typically coupled to serve as a vacuum chamber for ion beam processing (such as ion beam milling), electron microscopy (such as SEM or TEM), or a combination thereof.

During laser ablation, debris from a workpiece is produced having large kinetic energies (KEs). A background gas can be selected to reduce debris KE to hinder propagation toward optical system surfaces or other surfaces. For this reason, background gases having masses corresponding to debris mass may tend to be more effective in reducing debris KE than other gases. Alternatively, gases that are reactive with the debris or that have large collision cross sections can be used. In either case, the propagation of debris is diffused. Representative background gases include xenon fluoride (i.e., one or more of XeF₂, XeF₄, and XeF₆,), a fluorocarbon, a noble gas such as Xe, or other gases such as N₂, H₂O, SF₆, NF₃, and other halogenated precursors and mixtures thereof. Background gas pressures can be selected so that debris mean free paths (MFPs) are less than distances to surfaces to be protected such as optical windows. For example, for a surface a distance d from an area being ablated, an MFP can be selected that is less than *d, d*/*2, d*/*4, d*/*10,* or *d*/*20.* In addition, for charged debris particles, an external electrostatic field can be used solely or in conjunction with any of the disclosed approaches to provide kinetic energy reduction and/or debris deflection.

A variety of workpiece materials can be laser ablated, ion beam milled, and /or imaged with an electron beam. Representative materials include glasses, ceramics, semiconductors, epoxies, and metals, but other materials can be similarly processed. As used herein, background gas introduction can be referred to as "diffuse" when introduced without being directed at a particular surface for which contamination by debris is to be reduced. In some examples, the background gas is directed at a surface to be protected from debris, a surface associated with production of debris (such as a surface undergoing ablation) to inhibit debris production and/or propagation, or the background gas is introduced diffusely, without being specifically directed toward a particular surface Directed introduction of the background gas and diffuse introduction can be combined as well. In the examples, vacuum pressure is referred to zero pressure to indicate that pressure is less that the pressures obtained by introducing a background gas and correspond to pressures less than 10⁻³ to 10⁻⁹ Torr or other pressures suitable for ion beam milling or electron microscopy and are associated with MFPs that can be greater than a few meters. To reduce material redeposition, vacuum chamber pressures between 1 Pa and 10 kPa associated with much smaller MFPs such as less than 10 mm, 1 mm, 0.5 mm or less can be used as discussed further below.

As used in this application and in the claims, the singular forms "a," "an," and "the" include the plural forms unless the context clearly dictates otherwise. Additionally, the term "includes" means "comprises." Further, the term "coupled" does not exclude the presence of intermediate elements between the coupled items.

The systems, apparatus, and methods described herein should not be construed as limiting in any way. Instead, the present disclosure is directed toward all novel and non-obvious features and aspects of the various disclosed embodiments, alone and in various combinations and sub-combinations with one another. The disclosed systems, methods, and apparatus are not limited to any specific aspect or feature or combinations thereof, nor do the disclosed systems, methods, and apparatus require that any one or more specific advantages be present or problems be solved. Any theories of operation are to facilitate explanation, but the disclosed systems, methods, and apparatus are not limited to such theories of operation.

Although the operations of some of the disclosed methods are described in a particular, sequential order for convenient presentation, it should be understood that this manner of description encompasses rearrangement, unless a particular ordering is required by specific language set forth below. For example, operations described sequentially may in some cases be rearranged or performed concurrently. Moreover, for the sake of simplicity, the attached figures may not show the various ways in which the disclosed systems, methods, and apparatus can be used in conjunction with other systems, methods, and apparatus. Additionally, the description sometimes uses terms like "produce" and "provide" to describe the disclosed methods. These terms are high-level abstractions of the actual operations that are performed. The actual operations that correspond to these terms will vary depending on the particular implementation and are readily discernible by one of ordinary skill in the art.

In some examples, values, procedures, or apparatus' are referred to as "lowest", "best", "minimum," or the like. It will be appreciated that such descriptions are intended to indicate that a selection among many used functional alternatives can be made, and such selections need not be better, smaller, or otherwise preferable to other selections.

Examples are described with reference to directions indicated as "above," "below," "upper," "lower," and the like. These terms are used for convenient description, but do not imply any particular spatial orientation.

### Example 1

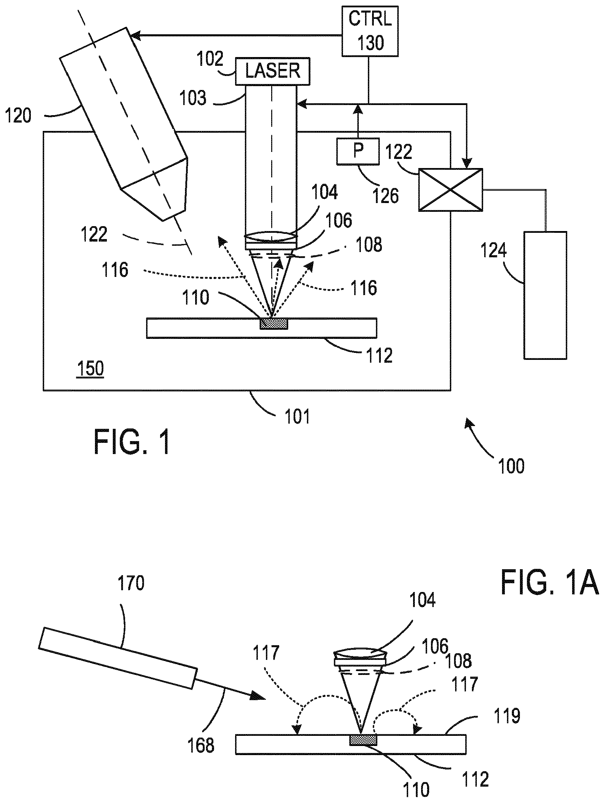

Referring to FIG. 1, a processing system 100 includes a vacuum chamber 101 that defines a processing volume 150 that provides a suitable environment such as a vacuum or a background gas at a selected pressure for processing a workpiece 112. A laser 102 or other optical source provides optical radiation to an optical system 103 that directs an optical beam 108 to a target area 110 on the workpiece 112. As illustrated, the optical system 103 includes an objective 104 that shapes the optical beam 108. An optical window 106 is situated to shield the objective 104 from processing debris propagating along paths such as paths 116 from the target area 110. An ion beam source 120 is situated to direct an ion beam along an axis 122 to the workpiece 112 for processing as well.

A background gas container 124 such as one or more gas cylinders or other background gas sources is coupled to a valve 122 so that the background gas can be introduced into the vacuum chamber 101. The background gas can be, for example, nitrogen, water vapor, carbon dioxide, oxygen, a noble gas, a fluorocarbon, or mixtures thereof. In some examples, a reactive gas is selected that is reactive with the processing debris. A pressure gauge 126 is situated in the processing volume 150 to provide a measurement of pressure to a controller 130. The controller 130 is also coupled to the valve 122, the laser 102, and the ion beam source 120 to regulate pressure in the processing volume 150 and select laser processing or ion beam processing. Typically, prior to or upon initiation of laser processing that is anticipated to generate contamination, the controller 130 causes the valve 122 to admit the background gas to the processing volume 150 to a preferred pressure, generally between 1 Pa and 7.5 kPa, 5 Pa and 10 kPa, 10 Pa and 5 kPa, 20 Pa and 5 kPa, 100 Pa and 50 kPa, 250 Pa and 20 kPa, 500 Pa and 10 kPa, 1 kPa and 5 kPa, other ranges between 0.5 and 20 kPa, 10⁻⁴ Pa to 2 Pa, 10⁻³ Pa to 1 Pa, 10⁻² Pa to 1 Pa, or other ranges between 10⁻⁴ Pa and 10 kPa. The selected pressure range can differ for different background gases and gas mixtures and different workpieces.

FIG. 1A illustrates the target area 110 on the workpiece 112 and shows paths 117 of debris from the target area 110 to adjacent areas on the workpiece 112. Introduction of a background gas as discussed above can increase redeposition along such paths. The redeposition can be reduced using a suitable reactive background gas or in a subsequent laser processing step. Alternatively, a directed flow 168 of the same or a different background gas can be provided to a surface 119 of the workpiece 112 from a tube, nozzle, pipe, conduit, or other gas delivery device 170. The gas delivery device 170 can be coupled to a gas supply via a valve that is controlled to deliver the background gas during laser processing.

### Example 2

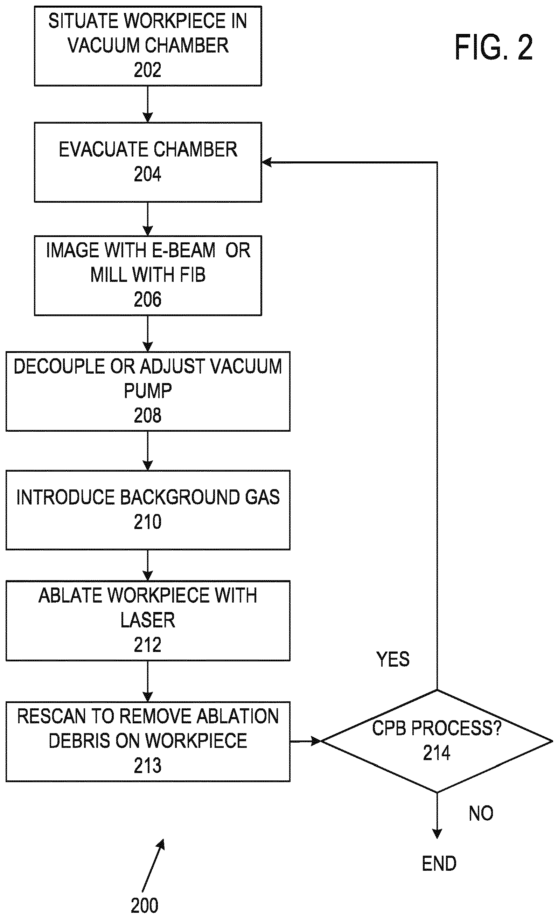

Referring to FIG. 2, a representative method 200 includes situating a workpiece in a vacuum chamber at 202 and evacuating the chamber at 204. At 206, the workpiece is evaluated, imaged, aligned, milled or otherwise subject to a processing or inspection process that is conducted in a vacuum environment such as electron beam imaging (for example, SEM, TEM, electron beam tomography, ion beam milling). At 208, the vacuum chamber can be decoupled from a vacuum pump that maintains vacuum in the vacuum chamber by, for example, using a valve to isolate the vacuum pump and the vacuum chamber. Alternatively, the vacuum pump can be adjusted by, for example, reducing the pumping rate. In some systems, turbomolecular pumps are used, and rotor speeds are reduced in anticipation of higher pressures associated with introduction of a background gas. At 210, a background gas is introduced into the vacuum chamber and the workpiece is ablated or other processes with an optical beam at 212. In some cases, after ablation, debris on the workpiece resulting from the ablation is removed with a laser exposure at 213, generally at lower power and lower laser exposure. If additional charged particle beam (CPB) processes or other processes conducted in vacuum are to be implemented, the vacuum chamber is evacuated again at 204 and CPB and laser processing are repeated.

In FIG. 2, steps 208 and 210 are shown sequentially but these steps can be performed simultaneously in completely or partially overlapping time intervals at the beginning/end of ablation. For instance, just after ablation is started, the vacuum pump speed can be decreased while background gas flow is started. The desired pressure (and pump speed) are then achieved at the beginning of the ablation process, within, for example, the first minute or minutes of the ablation process. Similarly, when reaching the end of the ablation process, pump speed can be increased and background gas flow decreases. This can eliminate or decrease the time delay needed to prepare the system for ablation and for the time for the system recover from then introduction of the background gas. The efficiency with which the deposition of debris or other ablation-induced artifacts is reduce may not be as great as achieved in sequential pumping reduction followed by background gas introduction. The disadvantages of any reduced efficiency in controlling debris deposition can be offset by the increased system throughput. Selection of sequential, simultaneous, or partially temporally overlapping can be selected based on, for example, the duration of ablation, material removal rate, sample composition, expected amount of material to be ablated, required throughput and other factors. A controller can be provided with processor executable instructions to select a suitable timing based on these and other considerations.

The method 200 can be performed with the workpiece in a single chamber so that moving the workpiece to different chambers for laser and CPB processes or imaging can be avoided. In addition, the chamber used for processing need not be vented to atmospheric pressure.

### Example 3

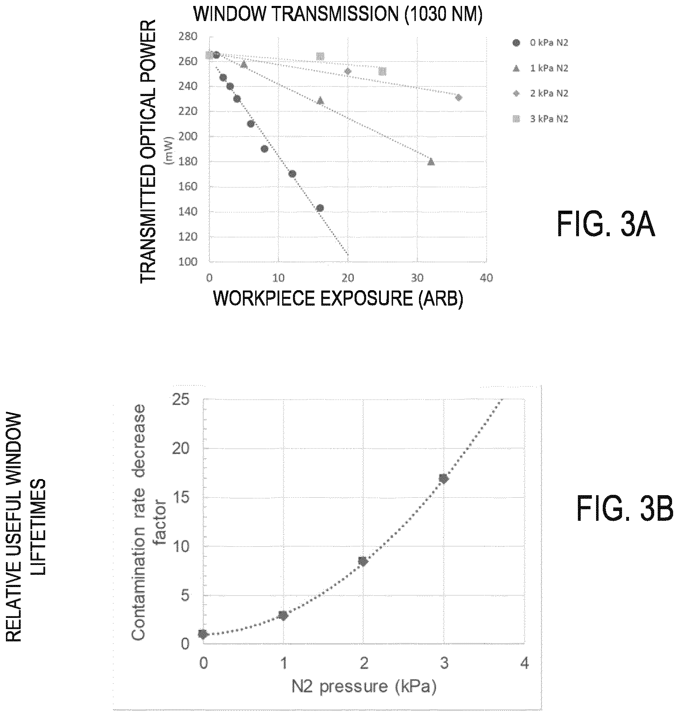

FIGS. 3A-3B illustrate selection of suitable pressure for a background gas for a representative background gas (N2 in this example). For purposes of this selection, optical window transmission is evaluated at various background gas pressures for a range of workpiece exposures in laser ablation. Workpiece exposure refers to a product of effective laser exposure and total exposure time or alternatively, extent of workpiece ablation. Effective laser exposure can be based on laser beam parameters such a peak and average powers, pulse duration and repetition rate, wavelength, and spot size. For the results of FIGS. 3A-3B, exposure wavelength was 1030 nm, and laser exposure parameters were constant. Beam spot size was about 15 µm, pulse energy was about 5 µJ, repetition rate was 60 kHz, and the sample was an MSC DDR SDRAM package. FIG. 3A shows the decrease of transmitted optical power as a function of exposure for N2 pressures of 0 kPa (vacuum), 1 kPa, 2 kPa, and 3 kPa. At the highest background pressure (3 kPa in this example), the transmitted optical power decreases substantially more slowly as a function of exposure than at 0 kPa (vacuum). By using a background gas, window transmission can be maintained for higher exposures and window replacement is not needed as quickly. Relative useful window lifetime as a function of N2 pressure is shown in FIG. 3B. Window lifetime can be associated with transmission decreases of 5%, 10%., 20%, 50% or other values. Similar curves to those of FIGS. 3A-3B can be obtained for other background gases (including mixtures) and pressures. N2 is selected as an example as it is readily available.

### Example 4

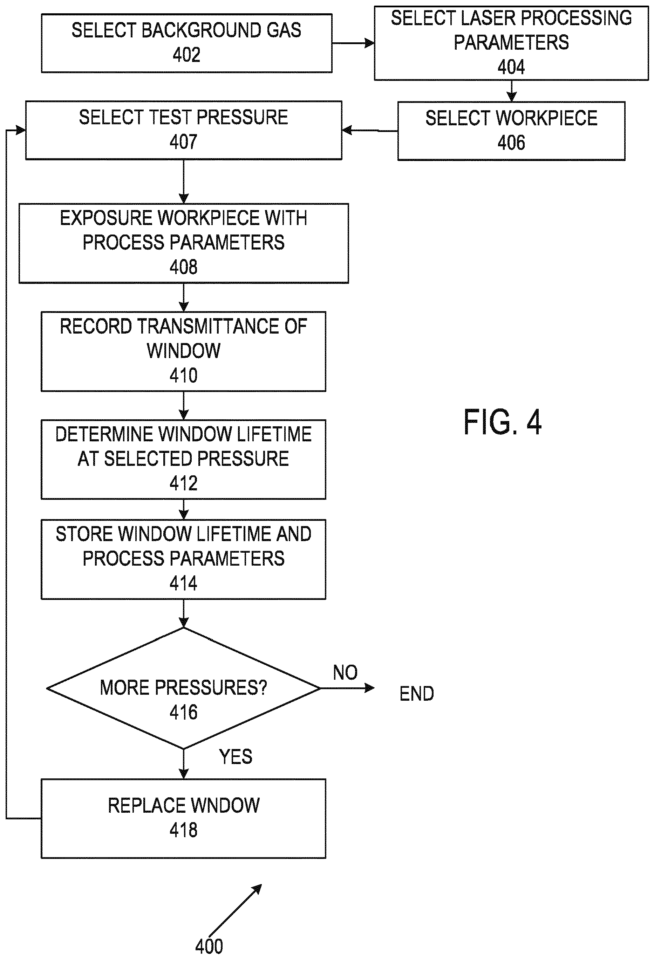

Referring to FIG. 4, a representative method 400 of configuring a background gas for reduction of contamination includes selecting a background gas at 402. The background gas can be selected based on reactivity with any anticipated processing debris, workpiece composition, to provide suitable energy transfer in collisions with debris, compatibility with other processes, availability, or other considerations.

At 404 laser processing parameters are selected to implement laser ablation or other processes. Representative parameters include laser wavelength, peak power, average power, beam spot size, intensity, state of polarization, total energy (exposure), pulse duration, pulse repetition rate, pulse shape, and scan rate. Convenient wavelengths are in a range of 400 nm to 1.6 µm. At 406, a representative workpiece is selected, and a background gas pressure to be evaluated (a test pressure) is selected at 407. At 408, the workpiece is exposed with the selected parameters and contamination is recorded at 410, typically by recording transmittance of an optical window as a function of exposure time. At 412, window lifetime is determined at the test pressure and window lifetime, pressure, and processing parameters stored for future use at 414. Window lifetime can be established based on a total exposure that reduces window transmittance by a selected values or to a selected range. For example, a window transmittance corresponding to 50%, 75%, 85%, 90%, 95% of an initial window transmittance of a window without debris can be selected. Window transmittance can be measured using a test optical beam and detector. If additional pressures are to be evaluated as determined at 416, a test window can be replaced at 418 and then a test pressure selected again at 408. While establishing suitable background gases and pressures can be done in a vacuum chamber, vacuum is not required and other pressure-controlled chambers can be used.

### Example 5

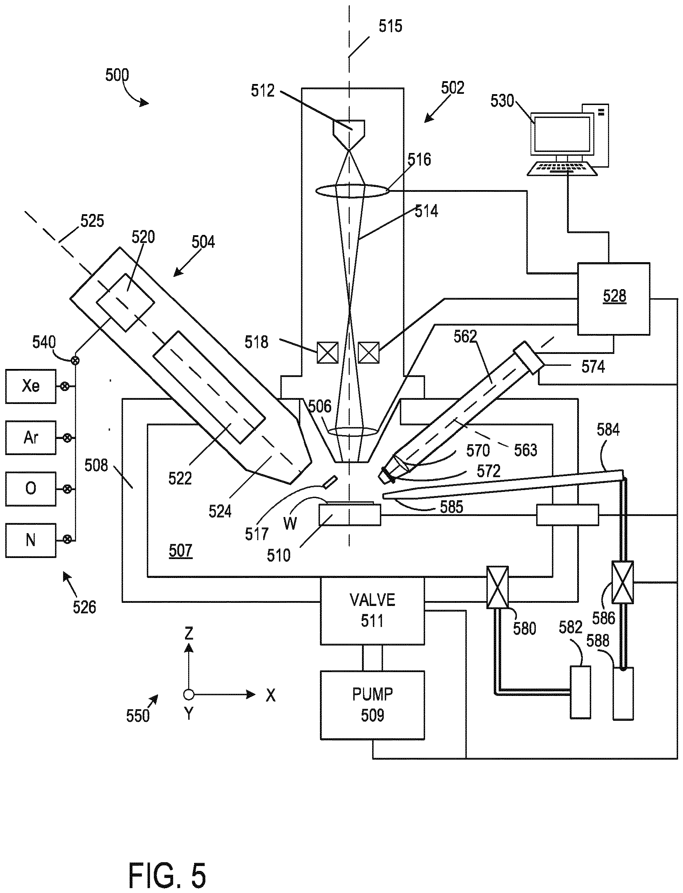

Referring to FIG. 5, in a representative embodiment, a processing system 500 comprises a scanning electron microscope (SEM) 502 and an ion beam column 504. The SEM 502 can comprise one or more charged particle beam (CPB) lenses such as a condenser lens 516 and an objective lens 506. In some embodiments, one or more CPB lenses can be magnetic lenses, and particularly, the objective lens 506 can be a magnetic objective lens. The ion beam column 504 is arranged to provide a focused ion beam (FIB) to a workpiece W that is secured to a stage 510 that can provide rotations and translations. The SEM 502 is situated for production of an image of the workpiece W. The SEM 502 and the ion beam column 504 can be mounted to a vacuum chamber 508 that defines a chamber volume 507 housing the stage 510 and the workpiece W. The vacuum chamber 508 can be evacuated using one or more vacuum pumps 509 that are coupled to the vacuum chamber 508 with a valve 511. The stage 510 can provide movement in the X-Y plane as shown with respect to a coordinate system 550, wherein a Y-axis is perpendicular to a plane of the drawing. The stage 510 can further provide workpiece movement vertically (along a Z-axis) to compensate for variations in the height of the workpiece W. In some embodiments, the SEM 502 can be arranged vertically above the workpiece W and can be used to image the workpiece W, and the ion beam column 504 can be arranged at an angle and can be used to machine and/or process the workpiece W. FIG. 5 shows an exemplary orientation of the SEM 502 and the ion beam column 504. In some examples, the stage 510 can be tilted so that either an electron beam such as an SEM electron beam or an ion beam such as focused ion beam (FIB) can be applied from vertically below the sample for various milling or imaging operations.

The SEM 502 can comprise an electron source 512 and can be configured to manipulate a "raw" radiation beam from the electron source 512 and perform upon it operations such as focusing, aberration mitigation, cropping (using an aperture), filtering, etc. The SEM 502 can produce a beam 514 of input charged particles (e.g., an electron beam) that propagates along a particle-optical axis 515. The SEM 502 can generally comprise one or more lenses (e.g., CPB lenses) such as the condenser lens 516 and the objective lens 506 to focus the beam 514 onto the workpiece W. In some embodiments, the SEM 502 can be provided with a deflection unit 518 that can be configured to steer the beam 514. For example, the beam 514 can be steered in a scanning motion (e.g., a raster or vector scan) across a sample being investigated. A charged particle detector 517 such as an ion or electron detector is situated to receive charged particles (for example, electrons, ions, secondary electrons) from the workpiece W.

The processing system 500 also includes an optical system 562 that delivers an optical beam such as a laser beam to the workpiece W along an axis 563 to mill, ablate, or otherwise remove material. The laser beam can be scanned in a raster pattern or in other ways to apply one or more laser pulses to selected workpiece locations. Beam scanning can be accomplished with electro-optic, acousto-optic or mirror-based scanners (not shown) or by translation of the workpiece W with the stage 510. The optical system 562 includes an objective 570 that focuses the optical beam and a window 572 that is situated between the objective 570 and the workpiece W to prevent contamination of the objective 570. In some examples, the optical system 562 includes a laser 574, but a laser can be situated at other locations. Introduction of a background gas can reduce debris buildup on the window 572 (and other surfaces such as the detector 517 or surfaces of a pole piece of the objective lens 506) that are proximate and along a line of sight from the workpiece W. Because debris is distributed in a cosine distribution, material builds up in almost half of the chamber volume. Distribution is shifted from a surface normal if a sample surface is not perpendicular to the input laser beam. While window, detector, and selected other surfaces are particularly sensitive to debris, debris is widespread absent the background gas.

A background gas inlet valve 580 is situated to allow introduction of a first background gas from a first gas source 582 (typically a gas cylinder) into the chamber volume 507. As shown, the background gas is introduced at a location away from the workpiece W and diffuses throughout the chamber volume 507. In addition, a gas inlet 584 can be situated to direct a second background gas from a gas source 588 towards the workpiece W to reduce redeposition on the workpiece W. The gas inlet 584 can be made of a suitable tubing and be coupled into the vacuum chamber 507 with one or more vacuum fittings (no shown). The gas inlet 584 can include a nozzle 585 that directs the second background gas toward the workpiece W. A valve 586 couples the gas inlet 584 and the second gas source 588. In some cases, the first gas and the second gas are the same and can be supplied from a common gas source. In other examples, only a background gas that is directed to a surface such as surface of a workpiece W is used (such as from the nozzle 585). This directed background gas can be introduced at pressures as low as 0.5 to 5 Pa and as high as 100 Pa to 1 kPa, or at any of the pressures or pressure ranges used for indirect or diffuse introduction of the background gas, such as 1 Pa to 20 kPa.

The processing system 500 can further comprise a computer processing apparatus and/or a control unit 528 for controlling *inter alia* the deflection unit 518, charged particle beam (CPB) lenses 506, 516, and detectors (such as the detector 517), and for displaying information gathered from the detectors on a display unit. The control unit 528 can also control an ion beam 524 to mill or otherwise remove material from selected areas of the workpiece W. In some cases, a control computer 530 is provided to establish various excitations, control FIB milling, align the workpiece W before or after ion beam milling operations, record imaging data, control the laser optical system and the laser, introduction of a background gas, valves, vacuum pumps, and generally control operation of the SEM 502, the ion beam column 504, and the optical system 562.

Referring still to FIG. 5, the ion beam column 504 can comprise an ion source (e.g., a plasma source 520) and ion beam optics 522. In the illustrated embodiment, the ion beam column 504 is a plasma focused ion beam (PFIB), however, in other embodiments, the ion beam column 504 can be a standard focused ion beam (FIB) having a liquid metal ion source (LMIS), or any other ion source compatible with a focused ion beam column. The ion beam column 504 can produce and/or direct the ion beam 524 along an ion-optical axis 525. As mentioned above, the ion column 504 can be used to perform imaging, processing and/or machining operations on the substrate, such as incising, milling, etching, depositing, etc. The ion source 520 can be fluidly coupled to a plurality of gases via a gas manifold 526 that includes gas sources coupled by respective valves to the ion source 520. A valve 540 is situated to selectively couple gases from the gas manifold 526 to the ion source 520. Exemplary gases include, but are not limited to, xenon, argon, oxygen, and nitrogen as shown in FIG. 5. During operation of the ion source 520, a gas can be introduced, where it becomes charged or ionized, thereby forming a plasma. Ions extracted from the plasma can then be accelerated through the ion beam column 504, becoming an ion beam.

In typical examples, the optical system 562 is used to ablate a surface of the workpiece after introduction of the first background gas. The second background gas is directed to the surface of the workpiece during ablation to reduce debris build-up on the workpiece surface. Debris can also be removed with an additional laser exposure, if desired. The second background gas is directed to the workpiece to reduce workpiece contamination, but can be directed at any other components or surfaces at which contamination reduction is desirable, such as at surfaces of charged particle or other detectors, vacuum chamber windows, or ion or electron beam optical elements. In some examples, the introduction of the first background gas reduces contamination throughout, and the second background gas and directional introduction are unnecessary.

### Example 6

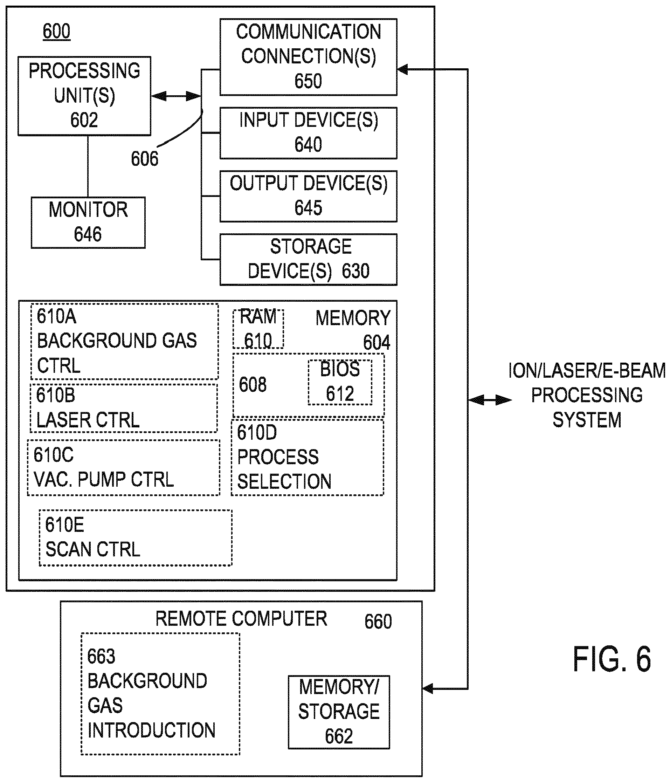

In some examples, one or more of ion beam milling, laser processsing such as laser ablation, electron microscopic imaging, and substrate evaluation are controlled with computer-executable instructions stored in one or more computer readable storage devices either at or near an ion beam/electron beam/laser beam system or coupled via a wide area network. FIG. 6 and the following discussion are intended to provide a brief, general description of an exemplary computing environment for controlling these operations. In other examples, individual processor-based controls can be provided for sample stages, electron columns, ion beam columns, laser operation, background gas selection and introduction (diffuse or directional), or image and sample evalution. The disclosed technology may be implemented with other computer system configurations, including hand held devices, multiprocessor systems, microprocessor-based or programmable consumer electronics, network PCs, minicomputers, mainframe computers, and the like. The disclosed technology may also be practiced in distributed computing environments where tasks are performed by remote processing devices that are linked through a communications network.

With reference to FIG. 6, an exemplary system for implementing the disclosed technology includes a general purpose computing device in the form of an exemplary conventional PC 600, including one or more processing units 602, a system memory 604, and a system bus 606 that couples various system components including the system memory 604 to the one or more processing units 602. The system bus 606 may be any of several types of bus structures including a memory bus or memory controller, a peripheral bus, and a local bus using any of a variety of bus architectures. The exemplary system memory 604 includes read only memory (ROM) 608 and random access memory (RAM) 610. A basic input/output system (BIOS) 612, containing the basic routines that help with the transfer of information between elements within the PC 600, is stored in ROM 608. In the example of FIG. 6, data and processor-executable instructions for controlling background gas introduction such as background gas selection, background gas pressure, directional or difuse introduction are stored in a memory 610A. Data and data and processor-executable instructions for laser and optical system control are stored in a memory portion 610B. Data and data and processor-executable instructions for vacuum pump control are stored in a memory portion 610C. Data and data and processor-executable instruction for selection and operation of ion beam milling, laser processing, and electron beam imaging are stored in a memory portion 610D. Scan instructions are stored in a memory portion 610E.

The exemplary PC 600 further includes one or more storage devices 630 such as a hard disk drive for reading from and writing to a hard disk, a magnetic disk drive for reading from or writing to a removable magnetic disk, and an optical disk drive. Such storage devices can be connected to the system bus 606 by a hard disk drive interface, a magnetic disk drive interface, and an optical drive interface, respectively. The drives and their associated computer readable media provide nonvolatile storage of computer-readable instructions, data structures, program modules, and other data for the PC 600.

A number of program modules may be stored in the storage devices 630 including an operating system, one or more application programs, other program modules, and program data. A user may enter commands and information into the PC 600 through one or more input devices 640 such as a keyboard and a pointing device such as a mouse. A monitor 646 or other type of display device is also connected to the system bus 606 via an interface, such as a video adapter. Output devices 645 such as printers can also be provided.

The PC 600 may operate in a networked environment using logical connections to one or more remote computers, such as a remote computer 660. In some examples, one or more network or communication connections 650 are included. The remote computer 660 may be another PC, a server, a router, a network PC, or a peer device or other common network node, and typically includes many or all of the elements described above relative to the PC 600, although only a memory storage device 662 has been illustrated in FIG. 6. The personal computer 600 and/or the remote computer 660 can be connected to a logical a local area network (LAN) and a wide area network (WAN). As shown in FIG. 6, the remote computer 660 includes the memory storage device 662 as well as a memory 663 for data and processor-executable instrucations for ion beam milling and shield and fiducial formation and other control operations.

While the computing environment is described with reference to a personal computer 600, other programmable devices such as one or more programmable logic devices (PLDs) can be used.

In view of the many possible embodiments to which the principles of the disclosure may be applied, it should be recognized that the illustrated embodiments are only examples and should not be taken as limiting the scope of the disclosure.

## Claims

1. A method of laser and ion beam processing, comprising
situating a workpiece in a vacuum chamber of a charged particle microscope;
establishing a background gas pressure of between about 10⁻⁴ Pa and 10 kPa in the vacuum chamber by introducing a background gas into the vacuum chamber; and
directing a laser beam to the workpiece in the vacuum chamber to ablate a portion of the workpiece.

2. The method of claim 1, further comprising isolating the vacuum chamber from a vacuum pump coupled to the vacuum chamber when introducing the background gas into the vacuum chamber.

3. The method of claim 2, wherein the background gas is one or more of one or more of XeF₂, XeF₄, and XeF₆, a fluorocarbons, a noble gas, N₂, H₂O, SF₆, and NF₃, and other halogenated precursors and mixtures thereof.

4. The method of claim 1, where the background gas is introduced to the vacuum chamber at a location remote from the ablated portion of the workpiece.

5. The method of claim 2, further comprising reducing a pumping rate of the vacuum pump prior to or as the background gas pressure is established.

6. The method of claim 3, further comprising evacuating the background gas from the vacuum chamber and processing or imaging the workpiece with a charged-particle beam of the charged particle microscope.

7. The method of claim 1, wherein the background gas is introduced into the vacuum chamber by directing the background gas toward a surface of the workpiece.

8. The method of claim 1, further comprising selecting a surface to be protected from deposition of ablation debris, wherein the background gas is introduced into the vacuum chamber by directing the background gas toward the selected surface.

9. A processing apparatus, comprising:
a vacuum chamber;
a laser optical system that includes an objective situated within the vacuum chamber and operable to direct an optical processing beam to a workpiece to remove material from the workpiece;
a charged-particle-beam (CPB) optical system situated to direct a charged particle beam to the workpiece; and
a process controller coupled to the vacuum chamber to introduce a background gas to inhibit deposition of workpiece material on the laser optical system during processing with the laser optical system.

10. The processing apparatus of claim 9, further comprising a valve responsive to the process controller and situated to introduce the background gas into the vacuum chamber.

11. The processing apparatus of claim 10, wherein the background gas is one or more of XeF₂, XeF₄, and XeF₆, a fluorocarbon, a noble gas, N₂, H₂O, SF₆, NF₃, and halogenated precursors .

12. The processing apparatus of claim 10, wherein the process controller introduces the background gas to produce a vacuum chamber pressure greater than 5 Pa.

13. The processing apparatus of claim 10, further comprising a pressure gauge situated to measure pressure in the vacuum chamber, wherein the process controller is coupled to the pressure gauge and is operable to introduce the background gas into the vacuum chamber based on the measured pressure.

14. The processing apparatus of claim 9, further comprising a gas outlet situated to direct a flow of the background gas to a surface of the workpiece.

15. The processing apparatus of claim 9, further comprising a vacuum pump coupled to the vacuum chamber and operable to evacuate the vacuum chamber, wherein the process controller is configured to decrease an evacuation rate of the vacuum pump from the vacuum chamber in association with introduction of the background gas.

16. The processing apparatus of claim 15, further comprising a pump valve that couples the vacuum pump to the vacuum chamber, wherein the process controller is operable to decrease the evacuation rate by adjusting the pump valve.
